# EUROPEAN PATENT SPECIFICATION

(11) **EP 1 761 029 B1**
(45) Date of publication and mention of the grant of the patent: **23.02.2011**
(21) Application number: 06117629.3
(22) Date of filing: 21.07.2006
(51) Int. Cl.: H04N 1/053, H04N 1/113

(54) **An image forming apparatus having an optical system that allows an easy detection of light beam passage**
Bilderzeugungsvorrichtung mit optischem System zur leichten Erkennung vom Durchlass von Lichtstrahlen
Appareil de formation d'images avec système optique permettant une détection facile du passage du rayon de lumière

(30) Priority: 28.07.2005 JP 2005218843
(43) Date of publication of application: 07.03.2007
(73) Proprietor: Ricoh Company, Ltd., Tokyo 143-8555 (JP)
(72) Inventor: Kusunose, Noboru Ricoh Company, Ltd., Tokyo 143-8555 (JP)
(74) Representative: Schwabe - Sandmair - Marx

(56) References cited:
- EP-A- 1 154 638
- EP-A2- 0 619 608

## Description

### BACKGROUND

### FIELD OF INVENTION

Exemplary aspects of the present invention relate to an image forming apparatus, and more particularly to an optical system and an image forming apparatus capable of allowing an easy detection of a starting position of writing with an optical beam in a main scanning direction relative to an image carrier.

### DISCUSSION OF THE BACKGROUND

Recently, related art image forming apparatuses using an electrophotographic method have been increasingly demanded for a high speed, a high image quality, and also a color printing enhancement. Such an image forming apparatus generally uses an optical system for generating a laser beam or laser beams to form an image.

The above-mentioned image forming apparatus which writes an image using the laser beam is commonly provided with a detector to determine an image writing position with the laser beam. More specifically, the detector detects an edge of the laser beam that is emitted from the optical system and scans a photosensitive member in a main scanning direction. At a detection of an edge of the laser beam, the detector generates a synchronous detection signal which determines an image writing position on the photosensitive member. Therefore, a key to satisfy such demands for a high speed and a high image quality is a control of the synchronous detection signal.

However, the laser beam may not follow the predetermined light paths due to, for example, misalignment of a reflection mirror and/or distortion of fixing members.

In a case where the laser beams do not accurately enter into the synchronous detection sensor, even if the laser beam enters through a cylindrical lens provided in front of the sensor, it may be difficult to confirm and correct the light path from the cylindrical lens side. Furthermore, when the laser beam does not enter into a light receiving portion with a narrow light receiving width in the synchronous detection sensor, it becomes more difficult to confirm a scanning position in the laser beam.

Furthermore, when seen from a side opposite to a mounting surface of a circuit board on which a synchronous detection sensor is mounted, the position of the synchronous detection sensor cannot be confirmed, thereby making it difficult to know whether or not the laser beam has entered into the light receiving portion. Consequently, without an oscilloscope, it may not be possible to confirm whether or not the laser beam has entered into the light receiving portion, and to perform repair and adjustment.

When repairing problems associated with the synchronous detection, since it is difficult to identify the direction from which the laser beam deviating from an incident position relative to the synchronous sensor scans, the laser beam may enter into eyes of an operator, and thus the safety of the operator may not be secured.

In a case where the circuit board on which the synchronous detection sensor is mounted is installed in a housing through a holder, generally, the synchronous detection unit including the circuit board and the holder (and the cylindrical lens) tends to be provided on both end portions of the housing. With downsizing of the writing unit, the size of the housing becomes smaller, and thus the gap between the synchronous detection unit and the side wall of the housing becomes smaller.

Accordingly, the operator is forced to see the surface opposite to the mounting surface of the circuit board on which the synchronous detection sensor is mounted from an obliquely upward direction, thereby making it difficult for the operator to identify the subscanning direction of the laser beam.

When the synchronous detection circuit board is installed through the holder or directly installed in the housing, the synchronous detection sensor is disposed in a further back of the housing or is surrounded by walls so as to prevent a misdetection due to a flare light. Consequently, it is difficult to confirm the synchronous detection circuit board. Furthermore, when the cylindrical lens is provided, it may not be possible to confirm the light receiving portion from the cylindrical lens side.

Many optical writing units are provided with a cover to prevent a contaminant such as toner from entering inside. Consequently, when a synchronous detection error once occurs, the cover is forced to be removed. For example, when a number of synchronous detection errors occur in a color printer, and the repair is not completed at once, the cover needs to be removed for a number of times, accordingly. Thus, every time the cover is removed, contaminants may enter and adhere to optical elements such as the lens and mirror, thereby generating a white streak in the formed image.

### SUMMARY

In view of the foregoing, an exemplary embodiment of the present invention provides an image forming apparatus which includes an optical system which allows an user to easily and accurately recognize a location of a synchronous detection sensor and an incident laser beam so that repair and adjustment thereof will be performed at ease without using a special equipment

To address or achieve the above and/or other objects, according to the invention set out in the appended claims an optical writing apparatus includes an image carrier, a light source, a rotary polygon mirror, an optical scanning mechanism, a synchronous detection sensor and a circuit board. The light source emits a laser beam. The rotary polygon mirror deflects the laser beam into a scanning laser beam. The optical scanning mechanism focuses the scanning laser beam on the image carrier forming an image. The synchronous detection sensor detects the scanning laser beam and generates a signal representing a write-start position on the image carrier in a main scanning direction. The circuit board is made from a material which is partially optically transparent, and includes a first surface on which the synchronous detection sensor is mounted at a predetermined position and a second surface opposite with the first surface. The second surface includes a first mark indicating a position corresponding to the predetermined position on the first surface.

Partially optically transparent means that it should be partially transparent in a wavelength range around the wavelength of the light of the light source.

An exemplary embodiment of the image forming apparatus may further include an enclosure which encloses the light source, the rotary polygon mirror, the optical scanning mechanism, the synchronous detection sensor and the circuit board. The enclosure has a first opening through which the optical scanning mechanism focuses the scanning laser beam on the sensor, and a second opening through which the first mark on the second surface of the circuit board is visible.

In one exemplary embodiment of the image forming apparatus, the second surface further includes a second mark indicating a position corresponding to a specific position of a synchronous detection area of the synchronous detection sensor on the first surface.

In one exemplary embodiment of the image forming apparatus, the second surface further includes a third mark indicating a scanning direction by the laser beam.

In one exemplary embodiment of the image forming apparatus, the circuit board includes at least one through hole in the vicinity of the synchronous detection sensor.

In one exemplary embodiment of the image forming apparatus, one of the at least one through hole is used for insertion of an electrical component.

An exemplary embodiment of the image forming apparatus may further include a holder which is disposed in the enclosure and fixedly supports the circuit board. The holder has protusions serving as fourth marks indicating a position corresponding to a specific position of a synchronous detection area of the synchronous detection sensor on the first surface.

In one exemplary embodiment of the image forming apparatus, the second surface further includes linear marks serving as fifth marks indicating a position corresponding to a specific position of a synchronous detection area of the synchronous detection sensor on the first surface.

In one exemplary embodiment of the image forming apparatus, the optical scanning mechanism may further include a cylindrical lens unit including a cylindrical lens arranged opposite to the circuit board relative to the synchronous detection sensor, and including protusions serving as sixth marks indicating a position corresponding to a specific position of a synchronous detection area of the synchronous detection sensor on the first surface.

In one exemplary embodiment of the image forming apparatus, the first mark is formed of a visibly distinguishable member.

In one exemplary embodiment of the image forming apparatus, the first mark is formed by printing.

In one exemplary embodiment of the image forming apparatus, the first mark is formed by a sticker.

In one exemplary embodiment of the image forming apparatus, the fourth marks are integrally formed with the holder.

In one exemplary embodiment of the image forming apparatus, the sixth marks are integrally formed with the cylindrical lens unit.

In one exemplary embodiment of the image forming apparatus, the circuit board and the synchronous detection sensor are installed together as a synchronous detection sensor unit on a housing of an optical writing apparatus.

In one exemplary embodiment of the image forming apparatus, the housing includes an opening to allow viewing of the surface opposite to the mounting surface of the circuit board on which the synchronous detection sensor is mounted.

In one exemplary embodiment of the image forming apparatus, the housing further includes a cover which prevents contaminants from entering into the apparatus. The cover includes an opening to allow viewing of opening the surface opposite to the mounting surface of the circuit board on which the synchronous detection sensor is mounted.

In one exemplary embodiment of the image forming apparatus, the opening includes an openably/closable sealing member which.

### BRIEF DESCRIPTION OF THE DRAWINGS

A more complete appreciation of the disclosure and many of the attendant advantages thereof will be readily obtained as the same becomes better understood by reference to the following detailed description of exemplary embodiments when considered in connection with the accompanying drawings, wherein:
FIG. 1 is a schematic diagram of a color image forming apparatus according to an exemplary embodiment of the present invention;
FIG. 2 a schematic diagram of an optical system of the color image forming apparatus of FIG. 1;
FIG. 3 is a perspective view illustrating an exemplary structure of an optical writing apparatus using two units of the optical system of FIG. 2 with a set of four photoreceptor drums;
FIG. 4 is a perspective view of a synchronous detection unit of the optical writing apparatus of FIG. 3 including a synchronous detection sensor;
FIG. 5 is a front view of a lens unit in the synchronous detection unit of FIG. 4, seen from an arrow A-direction in FIG. 4;
FIG. 6 is a side view of the synchronous detection unit of FIG. 4;
FIG. 7 is a front view of the synchronous detection unit of FIG. 4 from which the lens unit of FIG. 5 is removed;
FIG. 8 is a cross sectional view of the synchronous detection unit taken along a Z-plane in FIG. 4;
FIG. 9 is a front view of a circuit board on which the synchronous detection sensor is mounted in the synchronous detection unit of FIG. 4;
FIG. 10 is a rear view of the circuit board of FIG. 9;
FIG. 11 is a rear view of a modified circuit board of FIG. 9 seen from a rear side of a sensor mounting surface;
FIG. 12 is a rear view of another modified circuit board of FIG. 9 seen from a rear side of the sensor mounting surface;
FIG. 13 is a perspective view illustrating an exemplary structure in which a synchronous detection sensor unit is mounted in a housing of the optical writing apparatus;
FIG. 14 is a perspective view of the housing of FIG. 13;
FIG. 15 is a perspective view of a cover mounted on the housing of FIG. 13; and
FIG. 16 is a cross sectional view of the cover of FIG. 15.

### DETAILED DESCRIPTION OF EXEMPLARY EMBODIMENTS

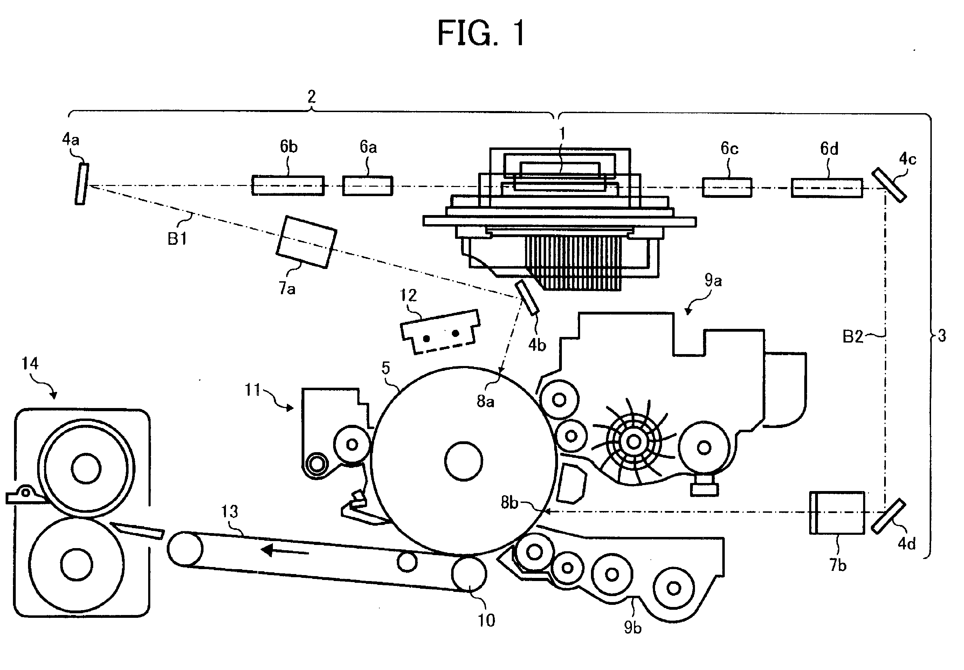

In describing exemplary embodiments illustrated in the drawings, specific terminology is employed for the sake of clarity. However, the disclosure of this patent specification is not intended to be limited to the specific terminology so selected and it is to be understood that each specific element includes all technical equivalents that operate in a similar manner. For the sake of simplicity of drawings and descriptions, the same reference numerals are given to materials and constituent parts having the same functions, and descriptions thereof will be omitted unless otherwise stated. Referring now to the drawings, wherein like reference numerals designate identical or corresponding parts throughout the several views, particularly to FIG. 1, a color image forming apparatus according to an exemplary embodiment of the present invention is described.

Example embodiments of the present invention are now explained below with reference to the accompanying drawings. The color image forming apparatus of FIG. 1 includes a polygon scanner 1 which is a rotary polygon mirror, an imaging optical system 2 and an imaging optical system 3 which are a pair of first and second imaging optical systems, respectively. The polygon scanner 1 and the first and second imaging optical systems 2 and 3 form an optical system. The first imaging optical system 2 includes reflecting mirrors 4a and 4b, f-θ lenses 6a and 6b, and a horizontal toroidal lens 7a. Similarly, the second imaging optical system 3 includes reflecting mirrors 4c and 4d, f-θ lenses 6c and 6d, and a horizontal toroidal lens 7b. The color image forming apparatus further includes a photoreceptor drum 5. Surrounding the photoreceptor drum 5, exposure units 8a and 8b corresponding to different colors, developing units 9a and 9b corresponding to different colors, a transfer unit 10, a cleaning unit 11, a charging unit 12, a conveyance belt 13 and a fixing unit 14 are provided. The photoreceptor drum 5 serves as an image carrier.

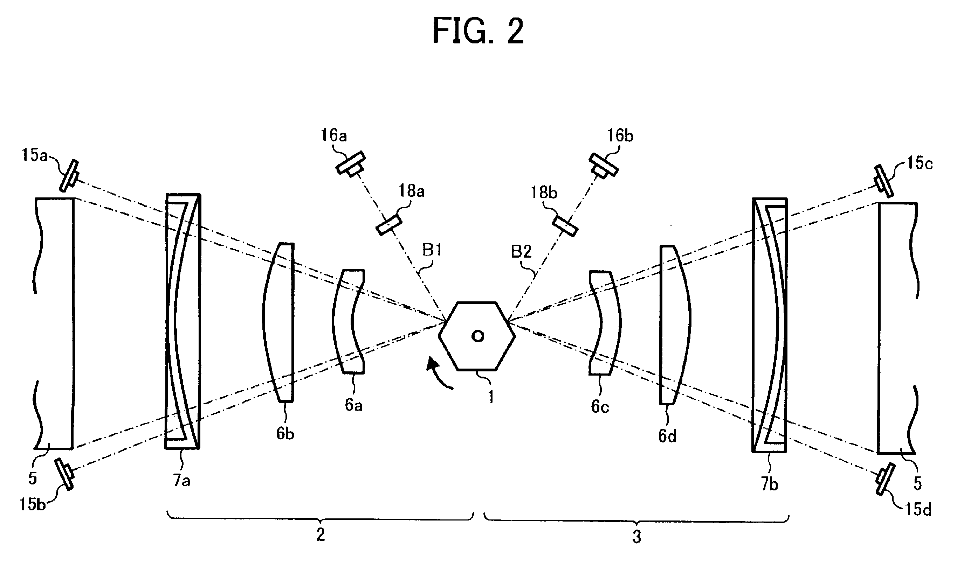

FIG. 2 is a partial plan view illustrating a structure of an optical system of the optical writing apparatus illustrated in FIG. 1. As illustrated in FIG. 2, the optical system provides two optically equivalent and symmetrical systems that control laser beams from the polygon scanner 1 to respective constituent parts of the first and second imaging optical systems 2 and 3, except for the reflecting mirrors 4a through 4d.

In FIG. 2, the polygon scanner 1 rotates in an arrow direction. The first imaging optical system 2 employs a two-point synchronous method in which synchronous detection sensors 15a and 15b are arranged at both ends of a scan starting position and a scan finishing position, respectively. Similarly, the second imaging optical system 3 employs the two-point synchronous method in which synchronous detection sensors 15c and 15d are arranged at both ends of a scan starting position and a scan finishing position, respectively.

On one side of the polygon scanner 1, a first laser beam emitting device 16a and a second laser beam emitting device 16b, each formed of a semiconductor laser diode (LD) which emits a laser beam onto different mirrors of the polygon scanner 1, are disposed. The polygon scanner 1 rotates so as to scan the laser beams emitted from the first laser beam emitting device 16a and the second laser beam emitting device 16b in a main scanning direction on the photoreceptor 5. The photoreceptor 5 rotates in a subscanning direction perpendicular to the main scanning direction.

The first laser beam emitting device 16a and the second laser beam emitting device 16b are operated based on image data which is input from a not-shown image data input device. In the optical writing apparatus including the first imaging optical system 2 and the second imaging optical system 3, in FIGs. 1 and 2, a first laser beam B1 emitted from the first laser beam emitting device 16a passes through a cylindrical lens 18a, is deflected by the polygon scanner 1, passes through the f-θ lenses 6a and 6b, and is reflected on the reflecting mirror 4a. Subsequently, the first laser beam B1 passes through the toroidal lens 7a, is reflected on the reflecting mirror 4b and scans the photoreceptor 5.

On the other hand, a second laser beam B2 emitted from the second laser beam emitting device 16b passes through a cylindrical lens 18b, is deflected by the polygon scanner 1, passes through the f-θ lenses 6c and 6d, and is reflected on the reflecting mirrors 4c and 4d. Subsequently, the second laser beam B2 passes through the toroidal lens 7b and scans the photoreceptor 5. Due to the rotation of the polygon scanner 1, the first beam B1 and the second beam B2 scan in the opposite direction from each other in the main scanning direction.

In such a manner, the laser beams B1 and B2 emitted from the two light sources of the first laser beam emitting device 16a and the second laser beam emitting device 16b are simultaneously deflected by the polygon scanner 1 in the direction corresponding to the main scanning direction. In the meantime, the surface of the photoreceptor 5 rotating in the subscanning direction is exposed to the laser beams in the exposure units 8a and 8b. Accordingly, electrostatic latent images corresponding to different colors are formed on the surface of the photoreceptor 5.

Toner particles of different colors are adhered by the developing units 9a and 9b to each electrostatic latent image formed on the photoreceptor 5 in the above-described manner so that the electrostatic latent images become visible as toner images. Each toner image is then transferred onto not-shown transfer paper in the transfer unit 10. Subsequently, the transfer paper is conveyed by the conveyance beit 13 to a paper ejecting part as shown by an arrow, and is applied heat and pressure in the fixing unit 14. Due to the fixing processing, the toner images are fixed on the transfer paper, and multi-color images are formed on the transfer paper.

In FIG. 1, the surface of the photoreceptor 5 is uniformly charged in the charging unit 12 before exposure. After the transfer processing, residual toner is removed and recovered in the cleaning unit 11.

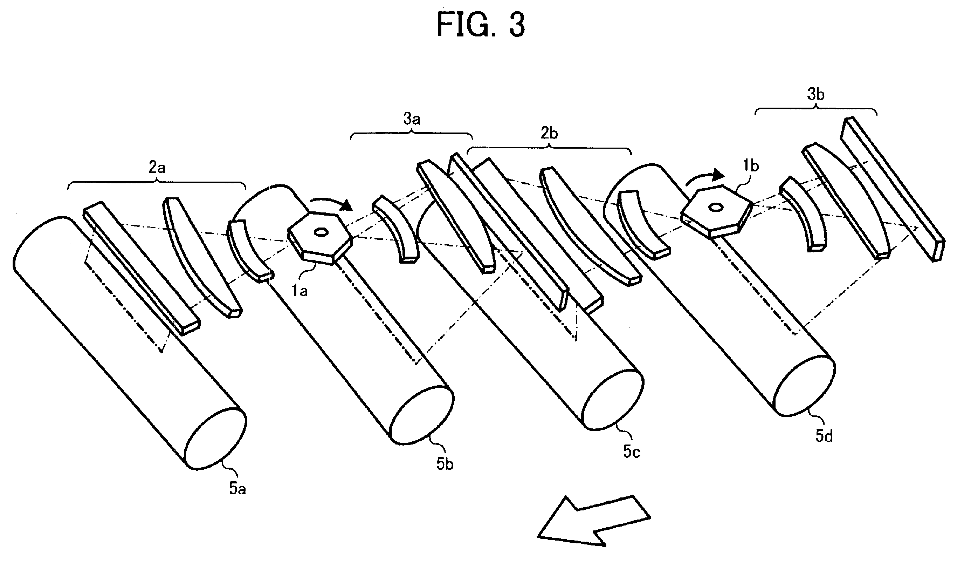

The optical writing apparatus using the two-point synchronous detecting method according to the exemplary embodiment of the present invention may be applied to an optical writing apparatus using a set of four photoreceptor drums shown in FIG. 3. FIG. 3 is a perspective view illustrating an exemplary structure of the optical writing apparatus with a set of four photoreceptor drums, including a plurality of photoreceptors 5a through 5d, a plurality of polygon scanners 1a and 1b, and a plurality of imaging optical systems 2a, 2b, 3a and 3b.

In FIG. 3, a first set, in which the first imaging optical system 2a and the second imaging optical system 3a are disposed at an optically symmetrical position around the first polygon scanner 1a, is provided. Adjacent to the first set of the first imaging optical system 2a and the second imaging optical system 3a, a second set, in which the first imaging optical system 2b and the second imaging optical system 3b are disposed at an optically symmetrical position around the polygon scanner 1b, is provided. When two optical writing apparatuses shown in FIG. 2 are horizontally aligned side by side, the structure shown in FIG. 3 is formed.

Laser beams emitted from the imaging optical systems 2a, 2b, 3a and 3b are imaged on photoreceptors 5a through 5d. Ultimately, toner images are formed on the photoreceptors 5a through 5d, respectively, and are transferred onto the transfer paper conveyed in the arrow direction.

In the two-point synchronous detecting method, an actual time necessary for scanning at a predetermined interval from the time of detecting laser beams by the synchronous detection sensor 15a or 15c to the synchronous detection sensor 15b or 15d is calculated by a control mechanism. The calculated time is then compared with a base time. Accordingly, the magnification error in the imaging optical systems may be detected.

Next, a description will be given of structures associated with the synchronous detection sensors of the exemplary embodiment of the present invention.

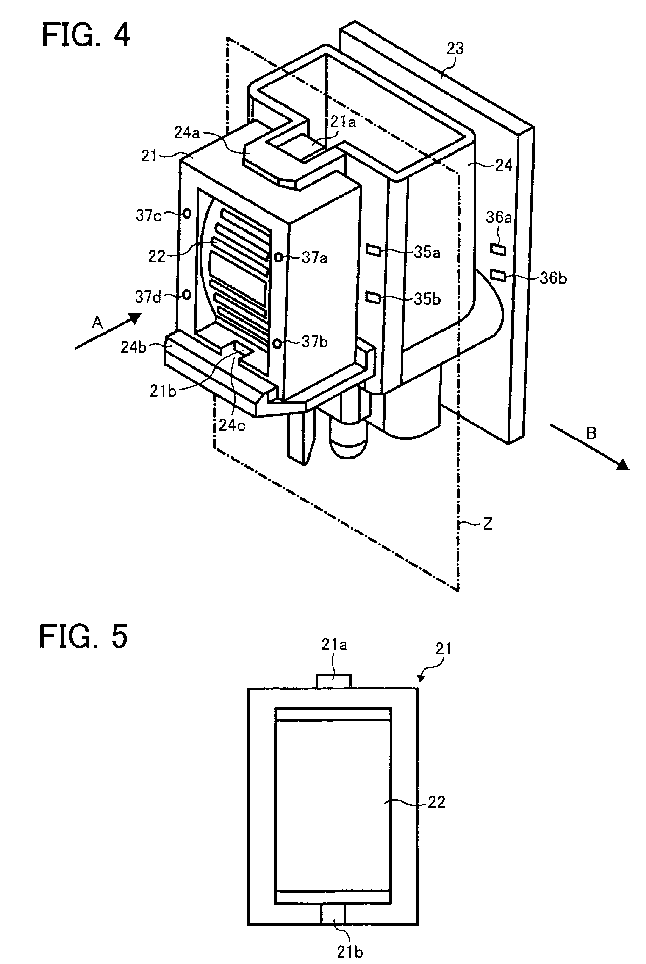

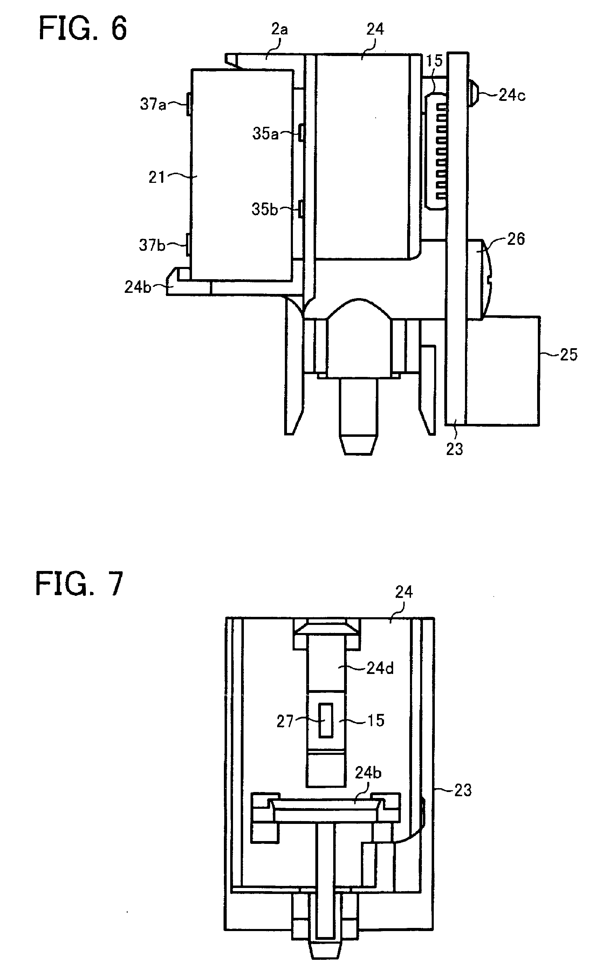

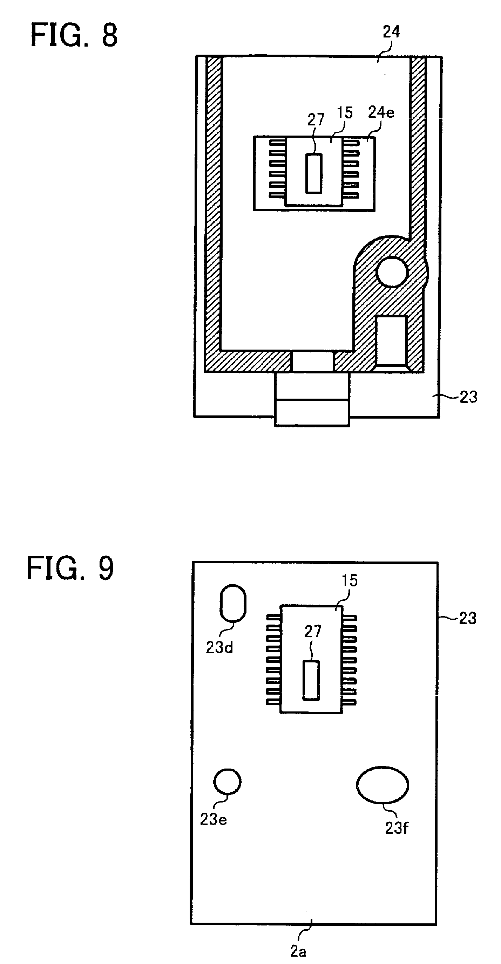

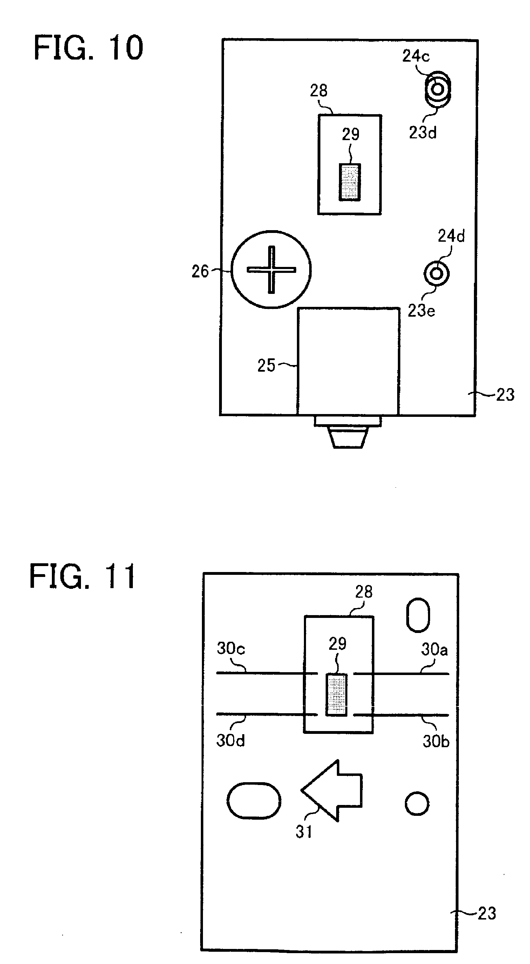

FIG. 4 is a perspective view illustrating a synchronous detection unit including a synchronous detection sensor. FIG. 5 is a front view of a lens unit of the synchronous detection unit of FIG. 4, seen from an arrow A-direction in FIG. 4. FIG. 6 is a side view of the synchronous detection unit of FIG. 4. FIG. 7 is a front view of the synchronous detection unit of FIG. 4 from which the lens unit is removed. FIG. 8 is a cross sectional view of the synchronous detection unit taken along a Z-plane in FIG. 4. FIG. 9 is a front view of a circuit board on which the synchronous detection sensor is mounted in the synchronous detection unit of FIG. 4. FIG. 10 is a rear view of the circuit board on which the synchronous detection sensor of FIG. 9 is mounted.

A lens unit 21 is made from resin and holds a cylindrical lens 22 disposed in front of the synchronous detection sensor 15. A circuit board 23 is formed of an optically-transparent member on which the synchronous detection sensor 15 is mounted. A holder 24 is made from resin and secures a gap between the cylindrical lens 22 of the lens unit 21 and the synchronous detection sensor 15 on the circuit board 23. The area of the circuit board 23 is larger than the area of the holder 24.

In FIG. 4, a laser beam enters from the A-direction and scans from the left to right direction shown by an arrow B. In FIG. 4, the lens unit 21 and the holder 24 are in contact with each other, however, the lens unit 21 may be disposed apart from the holder 24. When the lens unit 21 is placed on a carrier 24b of the holder 24, the lens unit 21 is regulated in an optical axis direction so as to prevent the lens unit 21 from moving. In other words, a protrusion 21a of the lens unit 21, a hook portion 24a of the holder 24, a recess portion 21b of the lens unit 21 and a protrusion 24c of the holder 24 are fitted with each other so that the position of the lens unit 21 is determined. Accordingly, due to a spring effect of the lens unit 21 and the holder 24, the lens unit 21 and the holder 24 are held with each other and are integrally unitized.

On the circuit board 23, as shown in FIGs. 9 and 10, the synchronous sensor 15 and the connector 25 are mounted, and the positions thereof are determined by fitting protrusions 24c and 24d provided on the holder 24 into through-holes 23d and 23e provided in the circuit board 23. The position determining method is not limited to the above-described structure. The position determining method may include, for example, a method in which a peripheral portion of the circuit board 23 and a portion of the holder 24 are fitted with each other.

Furthermore, the circuit board 23 and the holder 24 are fastened by a screw 26, and a hole 23f into which the screw 26 is inserted is provided in the circuit board 23. A fastening method may include a structure in which the circuit board 23 and the holder 24 are engaged with each other by taking advantage of elasticity of resin from which the circuit board 23 and the holder 24 are made.

A light receiving portion 27 which receives an incident laser beam is provided in the synchronous detection sensor 15. The laser beam scans over the light receiving portion 27, generating electric signals through photoelectric conversion. Accordingly, a passage of the laser beam is detected so that synchronous detecting signals are output.

The holder 24 holds the cylindrical lens 22 relative to the synchronous detection sensor 15. In the exemplary embodiment, a light source which emits a visible beam as the laser beam is utilized. The cylindrical lens 22 is disposed such that the laser beams which enter into the synchronous detection sensor 15 are concentrated on the synchronous detection sensor 15.

As shown in FIG. 7, in the holder 24, a hole 24d is formed such that the light receiving portion 27 of the synchronous detection sensor 15 is visible from outside, when the cylindrical lens 22 is removed from the lens unit 21. Furthermore, in the holder 24, as shown in FIG. 8, an opening 24e is formed on the side near the synchronous detection sensor 15.

In FIG. 7, when the cylindrical lens 22 is removed, a package of the synchronous detection sensor 15 and the light receiving portion 27 may be confirmed through the hole 24d provided in the holder 24. The width of the opening of the hole 24d is configured such that the hole 24d does not cut off angled incident laser beams.

In FIGS. 9 and 10, on the circuit board 23, the synchronous detection sensor 15 is mounted on one side thereof, and the connector 25 is mounted on the other side thereof. In the exemplary embodiment, the synchronous detection sensor 15 and the connector 25 are mounted on the different sides of the circuit board 23.

For the circuit board 23, material that visible laser beams, to penetrate for example, glass epoxy resin, may be used. As long as light penetrates in the circuit beard 23, the material may be in any color. However, a color of creamy white better facilitates recognition of the laser beams. When the circuit board 23 is diffuse-printed in a white color, the laser beams may easily be seen.

As shown in FIGs. 10 and 11, on the side opposite of the mounting surface of the circuit board 23, on which the synchronous detection sensor 15 is mounted, a printing portion 28 is provided as a marking which indicates a position corresponding to the outer shape of the synchronous detection sensor 15 and the mounting position thereof. A printing portion 29 is provided as a marking which indicates a synchronous detection signal output region or a light receivable region in the light receiving portion 27.

The printing portions 28 and 29 are formed by means of a printing process, for example, silkscreen printing. The similar effect may be attained by creating a silkscreen print shape on a sticker or the like, and adhering the sticker. The printing pattern may include filling in all areas, printing an outer shape, or printing vertical lines.

As prescribed above, the circuit board 23 is formed of the optically transparent member that visible laser beams penetrate as described above. The printing portions 28 and 29 as a marking are provided on the side opposite to the mounting surface of the circuit board 23, on which the synchronous detection sensor 15 is mounted. Accordingly, the position at which the laser beams pass the synchronous detection sensor 15 and the position of the synchronous detection sensor 15 may easily be understood from the side opposite to the mounting surface of the synchronous detection sensor 15, or the side opposite to the scanning side of the laser beam. Thus, even in the optical writing unit such as a multi-color printer having a plurality of synchronous detection sensors 15, the location of errors may easily be specified.

Upon repair and adjustment, it may not be necessary to remove parts such as the cylindrical lens 22 from the holder 24 to which the printed circuit 23 is installed. Furthermore, an operator may be able to see the laser beams through the circuit board 23 so that the safety may be secured. Since the position of the laser beams may visually be confirmed, the operator may perform repair or adjustment without a measuring device such as an oscilloscope. Therefore, the operation time for repair and adjustment may be reduced.

As the marking, as shown in FIG. 11, linear printing portions 30a and 30c may be formed at a position corresponding to an uppermost installation position of the light receiving portion 27. Similar linear printing portions 30b and 30d may be formed at a position corresponding to a lowermost installation position of the light receiving portion 27. Furthermore, the printing portions 30a through 30d may be printed on a sticker by printing processing, for example, silkscreen printing, and the sticker may be adhered to the printed board 23.

As shown in FIG. 11, the printing pattern may include an arrow 31 indicating a scanning direction of the laser beams so that it is easily recognizable. Instead of the arrow 31, a triangular shape may also be used.

In a case of a laser beam, it is not safe when the light enters into the eyes of an operator. If the direction from which the light enters is known, the operator's attention may be drawn. In a similar manner described above, a shape, for example, the arrow 31, may be formed on a sticker, and the sticker may be adhered to the circuit board 23.

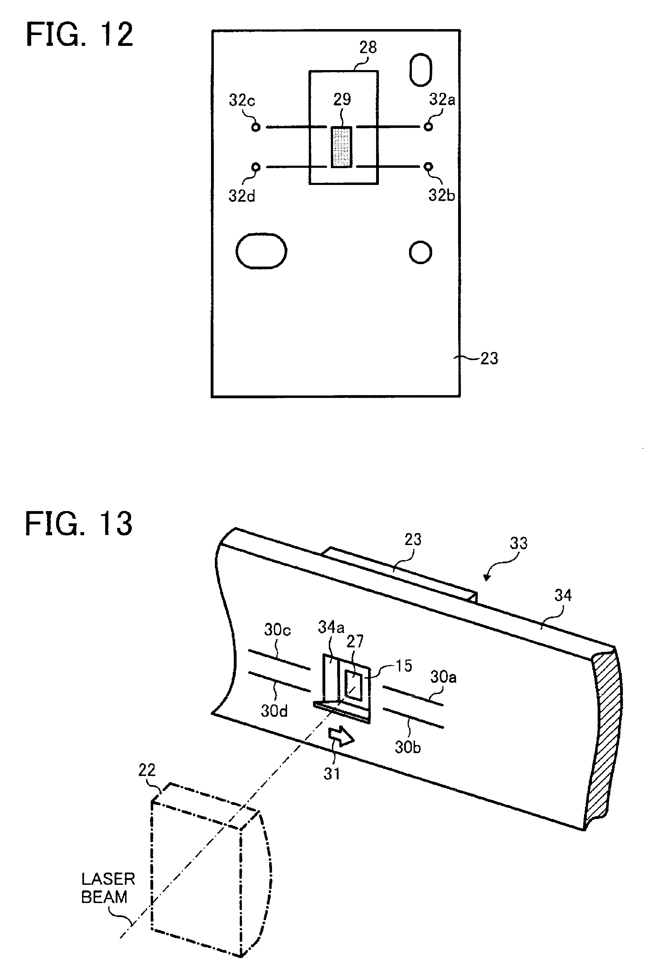

As shown in FIG. 12, instead of above-described printing, holes 32a and 32c may be formed at an uppermost position of a light receiving portion 29. Holes 32b and 32d may be formed at a lowermost position of the light receiving portion 29. In this case, the shape of the holes 32a through 32d may be circular or argular. At the positions where the holes 32a through 32d are formed, depressed portions may be formed so as to serve as a marking indicating the light receiving area.

The holes 32a through 32d may be through holes so that the holes may be used for insertion of electric components. Accordingly, it is not necessary to provide, on the circuit board 23, holes that do not associate with installation of electric components, and thus the wiring pattern of the circuit may become simple and easy. Furthermore, it may be possible to use unoccupied space on the circuit board 23 as the marking. When the through holes are used for insertion of the electric components, a comment may be printed adjacent to the holes as a marker.

FIG. 12 illustrates an example in which four holes 32a through 32d are formed. However, a single hole may be provided at each of the upper and lower positions so that the position of the laser beams in the subscanning direction may be confirmed. Furthermore, each of the holes at the upper and lower positions may be connected.

FIG. 13 illustrates an exemplary structure in which a synchronous detection sensor unit 33 is installed in a housing 34.

In the synchronous detection sensor unit 33, a hole 34a is provided in the housing 34 such that the laser beams may reach the light receiving portion 27 of the synchronous detection sensor 15. The printing portions 30a and 30c described in FIG. 11 are printed at the position corresponding to the uppermost position of the light receiving portion 27 in the housing 34, while the printing portions 30b and 30d are printed at the position corresponding to the lowermost position of the light receiving portion 27.

In this case, a protrusion may integrally be formed with the housing 34 at the printing position in the housing 34 or a sticker is adhered to the printing position. Accordingly, whether or not the laser beams pass over the light receiving portion 27 of the synchronous detection sensor 15 may visually be confirmed.

Furthermore, as shown in FIG. 4, protrusions 35a and 35b may be provided as a marking in the holder 24 so to be able to understand the position in the vertical direction in the light receiving portion 27 of the synchronous detection sensor 15. Furthermore, by providing printing portions 36a and 36b on the same surface as the surface of the circuit board 23 on which the synchronous detection sensor 15 is mounted, the position of the light receiving portion may be more easily understood.

As shown in FIG. 4, protrusions 37a through 37d may be provided as a marking so as to understand a laser beam incident area of the cylindrical lens 22, where the laser beams which reach the light receiving portion 27 of the synchronous detection sensor 15 enter. Instead of providing the protrusions 37a through 37d, in similar manners as described above, the marking may be formed by adhering a sticker or by printing or forming holes or depressed portions. In the exemplary embodiment, four holes 37a through 37d are provided. However, there may be two holes, each provided at the upper position and the lower position. Furthermore, the marking may be provided outside an effective light receiving area of the cylindrical lens 22.

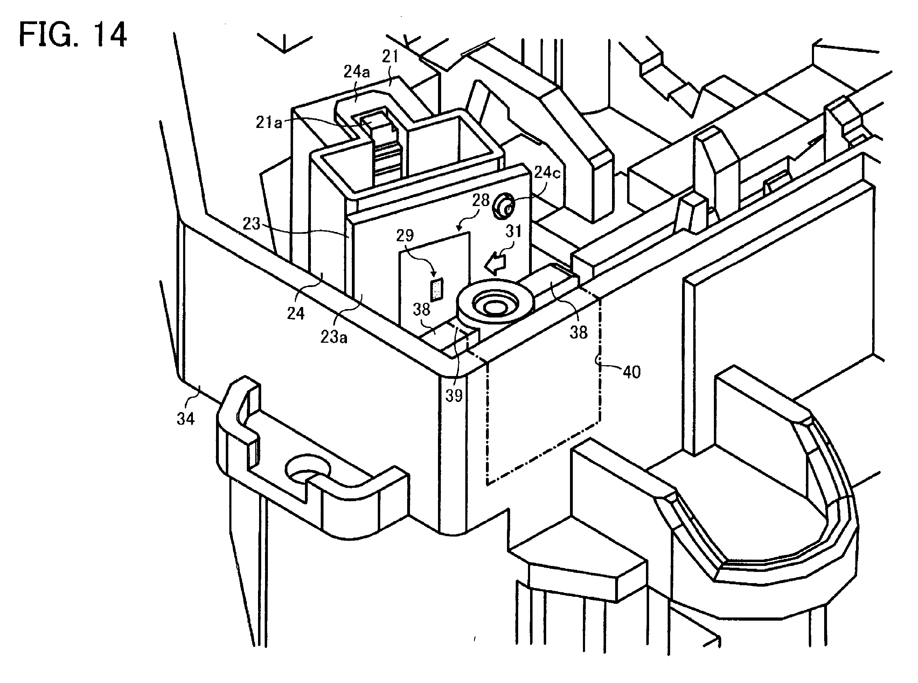

FIG. 14 is a perspective view illustrating a mounting area on which the optical writing apparatus is mounted in the image forming apparatus of the exemplary embodiment of the present invention. In the image forming apparatus, since ribs 38 of the housing 34 are arranged in a standing manner at a plurality of places, it is difficult to see a rear surface 23a of the circuit board 23. It is preferable that an opening 39 may be formed in a part of the ribs 38, and further an opening 40 may be formed in an outer wall of the housing 34 so that the scanning position of the laser beams may be confirmed from the direction directly behind the circuit board 23.

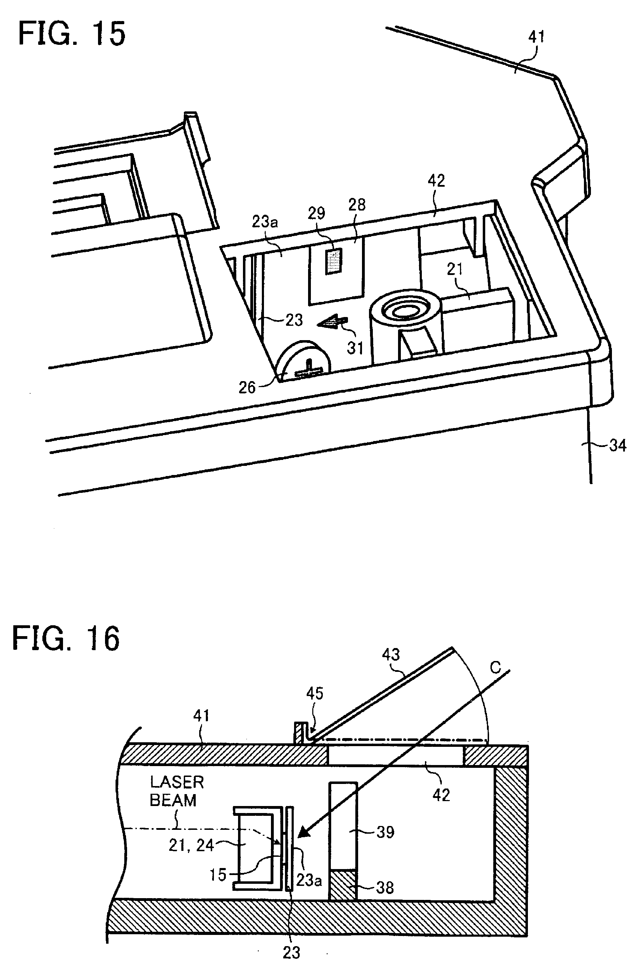

FIG. 15 is a diagram illustrating an exemplary structure in which an opening 42 is provided in a cover 41 which is placed on the upper portion of the housing 34 of the optical writing apparatus, and each marking indicating the synchronous detection sensor 15 and so forth may easily be confirmed. In such a manner, while operation, the scanning position of the laser beams may be confirmed without having the cover 41 removed. The open area of the opening 42 may be covered with a thin film sealing member so as to be able to prevent contaminants from entering the apparatus.

For example, as shown in FIG. 16, when the opening 42 is provided such that the rear surface 23a of the circuit board 23 may be seen from the upper direction of the cover 41 shown by an arrow C, and the opening 39 is provided in a part of the ribs 38 so that each marking may easily be confirmed, if a sealing member 43 is openably/closably provided covering the opening 42 of the cover 41, contaminants may be prevented from entering.

The sealing member 43 may be formed of a resin thin film member or a leaf spring, and fixed at an appropriate position of the cover 41 by an adhesive or a screw.

As shown in FIG. 16, a hinge portion 45 is provided at one end of the sealing member 43 such that the sealing member 43 is openable/closable. Furthermore, the sealing member 43 closes by the self-weight thereof and the spring force, when opening the sealing member 43 and then releasing it. Accordingly, covering the opening 42 may not be neglected. When the closing condition of the sealing member 43 is not well, a not-shown hook portion may be provided, or the sealing member 43 is secured by adhesives.

In the image forming apparatus and the optical writing apparatus of the exemplary embodiment of the present invention, the installation number of polygon scanners is not limited to the number described in this specification. In the exemplary embodiment, the descriptions are given assuming a color image forming apparatus. However, the present invention may be applied to a black and while image forming apparatus.

Numerous additional modifications and variations are possible in light of the above teachings. It is therefore to be understood that within the scope of the appended claims, the disclosure of this patent specification may be practiced otherwise than as specifically described herein.

## Claims

1. An optical writing apparatus comprises:
a light source (16) configured to emit a laser beam;
a rotary polygon mirror (1) configured to deflect the laser beam into a scanning laser beam;
an optical scanning mechanism configured to focus the scanning laser beam to an image on an image carrier (5);
a synchronous detection sensor (15) configured to detect the scanning laser beam and to generate a signal representing a write-start position on the image carrier (5) in a main scanning direction; and
a circuit board (23) made of partially optically transparent material and including a first surface on which the synchronous detection sensor (15) is mounted at a predetermined position and a second surface (23a) opposite to the first surface, the second surface (23a) including a first mark (28) indicating on the first surface the outer shape of said synchronous detection sensor (15).

2. The apparatus of Claim 1, further comprising:
an enclosure configured to enclose the light source (16), the rotary polygon mirror (1), the optical scanning mechanism, the synchronous detection sensor (15), and the circuit board (23), and having a first opening (34a) through which the optical scanning mechanism focuses the scanning laser beam to an image on the synchronous detection sensor (15), and a second opening (42) through which the first mark (28) on the second surface (23a) of the circuit board (23) is visible.

3. The apparatus of one of Claims 1 or 2, wherein the second surface (23a) further includes a second mark (29) indicating on the first surface, a position corresponding to a specific position of a synchronous detection area (27) of the synchronous detection sensor (15)

4. The apparatus of one of Claims 1 to 3, wherein the second surface (23a) further includes a third mark (31) indicating a scanning direction by the laser beam.

5. The apparatus of one of Claims 1 to 4, wherein the circuit board (23) includes at least one through hole (32a, 32b, 32c, 32d) in the vicinity of the synchronous detection sensor (15).

6. The apparatus of Claim 5, wherein one of the at least one through holes (32a, 32b, 32c, 32d) is used for insertion of an electrical component.

7. The apparatus of Claim 1, further comprising:
a holder (24) disposed in the enclosure, configured to fixedly support the circuit board (23), and having protrusions serving as fourth marks (35a, 35b) indicating a position corresponding to a specific position of a synchronous detection area of the synchronous detection sensor (15) on the first surface.

8. The apparatus of one of Claims 1 to 7, wherein the second surface includes linear marks serving as fifth marks (30a, 30b, 30c, 30d) indicating a position corresponding to a specific position of the synchronous detection area (27) of the synchronous detection sensor (15) on the first surface.

9. The apparatus of one of Claims 1 to 9, wherein the optical scanning mechanism includes
a cylindrical lens unit (21) including a cylindrical lens (22) arranged opposite to the circuit board (23) relative to the synchronous detection sensor (15), and including a protrusions serving as sixth marks (37a, 37b, 37c, 37d) indicating a position corresponding to a specific position of the synchronous detection area (27) of the synchronous detection sensor (15) on the first surface.

10. The apparatus of Claim 1, wherein the first mark (28) is formed of a visibly distinguishable member.

11. The apparatus of Claim 10, wherein the first mark (28) is formed by means of printing or by a sticker.

12. The apparatus of Claim 7, wherein the fourth marks (35a, 35b) are integrally formed with the holder.

13. The apparatus of Claim 9, wherein the sixth marks (37a, 37b, 37c, 37d) are integrally formed with the cylindrical Lens unit (21).

14. The apparatus of one of Claims 1 to 13, wherein the circuit board (23) and the synchronous detection sensor (15) are installed together as a synchronous detection sensor unit (33) in a housing (34) of an optical writing apparatus.

15. The apparatus of one of Claims 1 to 13, wherein the housing (34) comprises at an opening (42) to allow viewing of the surface (23a) opposite to the first surface of the circuit board (23) on which the synchronous detection sensor (15) is mounted, a cover (41) configured to prevent contaminants from entering into the apparatus, and the cover (41) includes said opening (42).

16. The apparatus of Claim 15, wherein the opening (42) comprises an openable/closable sealing member (43) configured to cover the opening (42).

17. An image forming apparatus, comprising:
an image carrier (5); and
an optical writing apparatus according to one of Claims 1 to 16.

## Patentansprüche

1. Optische Schreibvorrichtung, die umfasst:
eine Lichtquelle (16), die konfiguriert ist, um ein Laserstrahlenbündel auszusenden;
einen Drehpolygonspiegel (1), der konfiguriert ist, um das Laserstrahlenbündel in ein Abtastlaserstrahlenbündel abzulenken;
einen Mechanismus zum optischen Abtasten, der konfiguriert ist, um das Abtastlaserstrahlenbündel auf ein Bild auf einem Bildträger (5) zu fokussieren;
einen Synchrondetektionssensor (15), der konfiguriert ist, um das Abtastlaserstrahlenbündel zu detektieren und um ein Signal zu erzeugen, das eine Schreibstartposition auf dem Bildträger (5) in einer Hauptabtastrichtung repräsentiert; und
eine Leiterplatte (23), die aus einem optisch teilweise durchlässigen Material hergestellt ist und eine erste Oberfläche, auf der der Synchrondetektionssensor (15) an einer vorgegebenen Position montiert ist, und eine zweite Oberfläche (23a) gegenüber der ersten Oberfläche aufweist, wobei die zweite Oberfläche (23a) eine erste Markierung (28) enthält, die auf der ersten Oberfläche die äußere Form des Synchrondetektionssensors (15) angibt.

2. Vorrichtung nach Anspruch 1, die ferner umfasst:
eine Umschließung, die konfiguriert ist, um die Lichtquelle (16), den Drehpolygonspiegel (1), den Mechanismus zum optischen Abtasten, den Synchrondetektionssensor (15) und die Leiterplatte (23) zu umschließen, und eine erste Öffnung (34a) besitzt, durch die der Mechanismus zum optischen Abtasten das Abtastlaserstrahlenbündel auf einem Bild auf dem Synchrondetektionssensor (15) fokussiert, sowie eine zweite Öffnung (42) besitzt, durch die die erste Markierung (28) auf der zweiten Oberfläche (23a) der Leiterplatte (23) sichtbar ist.

3. Vorrichtung nach einem der Ansprüche 1 oder 2, wobei die zweite Oberfläche (23a) ferner eine zweite Markierung (29) enthält, die auf der ersten Oberfläche eine Position angibt, die einer bestimmten Position eines Synchrondetektionsbereichs (27) des Synchrondetektionssensors (15) entspricht.

4. Vorrichtung nach einem der Ansprüche 1 bis 3, wobei die zweite Oberfläche (23a) ferner eine dritte Markierung (31) aufweist, die eine Abtastrichtung durch das Laserstrahlenbündel angibt.

5. Vorrichtung nach einem der Ansprüche 1 bis 4, wobei die Leiterplatte (23) wenigstens ein Durchgangsloch (32a, 32b, 32c, 32d) in der Umgebung des Synchrondetektionssensors (15) aufweist.

6. Vorrichtung nach Anspruch 5, wobei eines des wenigstens einen Durchgangslochs (32a, 32b, 32c, 32d) verwendet wird, um eine elektrische Komponente einzusetzen.

7. Vorrichtung nach Anspruch 1, die ferner umfasst:
eine Halterung (24), die in der Umschließung angeordnet ist und konfiguriert ist, um die Leiterplatte (23) fest zu halten, und Vorsprünge besitzt, die als vierte Markierungen (35a, 35b) dienen, die eine Position angeben, die einer bestimmten Position eines Synchrondetektionsbereichs des Synchrondetektionssensors (15) auf der ersten Oberfläche entspricht.

8. Vorrichtung nach einem der Ansprüche 1 bis 7, wobei
die zweite Oberfläche geradlinige Markierungen aufweist, die als fünfte Markierungen (30a, 30b, 30c, 30d) dienen, die eine Position angeben, die einer bestimmten Position des Synchrondetektionsbereichs (27) des Synchrondetektionssensors (15) auf der ersten Oberfläche entspricht.

9. Vorrichtung nach einem der Ansprüche 1 bis 9, wobei der Mechanismus zum optischen Abtasten umfasst:
eine Zylinderlinseneinheit (21), die eine Zylinderlinse (22) enthält, die gegenüber der Leiterplatte (23) in Bezug auf den Synchrondetektionssensor (15) angeordnet ist und Vorsprünge enthält, die als sechste Markierungen (37a, 37b, 37c, 37d) dienen, die eine Position angeben, die einer bestimmten Position des Synchrondetektionsbereichs (27) des Synchrondetektionssensors (15) auf der ersten Oberfläche entspricht.

10. Vorrichtung nach Anspruch 1, wobei die erste Markierung (28) aus einem visuell unterscheidbaren Element gebildet ist.

11. Vorrichtung nach Anspruch 10, wobei die erste Markierung (28) durch Druck oder durch ein Etikett gebildet ist.

12. Vorrichtung nach Anspruch 7, wobei die vierten Markierungen (35a, 35b) einteilig mit der Halterung ausgebildet sind.

13. Vorrichtung nach Anspruch 9, wobei die sechsten Markierungen (37a, 37b, 37c, 37d) einteilig mit der Zylinderlinseneinheit (21) ausgebildet sind.

14. Vorrichtung nach einem der Ansprüche 1 bis 13, wobei die Leiterplatte (23) und der Synchrondetektionssensor (15) zusammen als eine Synchrondetektionssensoreinheit (33) in einem Gehäuse (34) einer optischen Schreibvorrichtung installiert sind.

15. Vorrichtung nach einem der Ansprüche 1 bis 13, wobei das Gehäuse (34) eine Öffnung (42), um ein Betrachten der Oberfläche (23a) gegenüber der ersten Oberfläche der Leiterplatte (23), auf der der Synchrondetektionssensor (15) montiert ist, zu ermöglichen, und eine Abdeckung (41), die konfiguriert ist, um ein Eindringen von Verunreinigung in die Vorrichtung zu verhindern, umfasst, wobei die Abdeckung (41) die Öffnung (42) enthält.

16. Vorrichtung nach Anspruch 15, wobei die Öffnung (42) ein zu öffnendes/zu schließendes Verschlusselement (43) umfasst, das konfiguriert ist, um die Öffnung (42) abzudecken.

17. Bilderzeugungsvorrichtung, die umfasst:
einen Bildträger (5); und
eine optische Schreibvorrichtung nach einem der Ansprüche 1 bis 16.

## Revendications

1. Appareil d'écriture optique comportant :
une source de lumière (16) configurée pour émettre un faisceau laser ;
un miroir polygonal rotatif (1) configuré pour dévier le faisceau laser en un faisceau laser de balayage ;
un mécanisme de balayage optique configuré pour concentrer le faisceau laser de balayage sur une image sur un support d'image (5) ;
un capteur de détection synchrone (15) configuré pour détecter le faisceau laser de balayage et pour générer un signal représentant une position de départ d'écriture sur le support d'image (5) dans une direction de balayage principale ; et
une carte de circuit (23) constituée d'un matériau partiellement transparent au point de vue optique et comprenant une première surface sur laquelle le capteur de détection synchrone (15) est monté dans une première position et une seconde surface (23a) opposée à la première surface, la seconde surface (23a) comprenant un premier repère (28) indiquant, sur la première surface, la forme extérieure dudit capteur de détection synchrone (15).

2. Appareil selon la revendication 1, comportant en outre :
une enceinte configurée pour contenir la source de lumière (16), le miroir polygonal rotatif (1), le mécanisme de balayage optique, le capteur de détection synchrone (15), et la carte de circuit (23), et
possédant un premier orifice (34a) par l'intermédiaire duquel le mécanisme de balayage optique concentre le faisceau laser de balayage sur une image sur le capteur de détection synchrone (15), et un second orifice (42) par l'intermédiaire duquel le premier repère (28) sur la seconde surface (23a) de la carte de circuit (23) est visible.

3. Appareil selon l'une des revendications 1 ou 2, dans lequel la seconde surface (23a) comprend en outre un second repère (29) indiquant sur la première surface, une position correspondant à une position spécifique d'une zone de détection synchrone (27) du capteur de détection synchrone (15).

4. Appareil selon l'une des revendications 1 à 3, dans lequel la seconde surface (23a) comprend en outre un troisième repère (31) indiquant une direction de balayage par le faisceau de balayage.

5. Appareil selon l'une des revendications 1 à 4, dans lequel la carte de circuit (23) comprend au moins un trou traversant (32a, 32b, 32c, 32d) à proximité du capteur de détection synchrone (15).

6. Appareil selon la revendication 5, dans lequel l'un d'au moins l'un des trous traversants (32a, 32b, 32c, 32d) est utilisé pour l'insertion d'un composant électrique.

7. Appareil selon la revendication 1, comportant en outre :
un support (24) disposé dans l'enceinte, configurée pour supporter fixement la carte de circuit (23), et possédant des parties saillantes servant de quatrièmes repères (35a, 35b) indiquant une position correspondant à une position spécifique d'une zone de détection synchrone du capteur de détection synchrone (15) sur la première surface.

8. Appareil selon l'une des revendications 1 à 7, dans lequel la seconde surface comprend des repères linéaires servant de cinquièmes repères (30a, 30b, 30c, 30d) indiquant une position correspondant à une position spécifique de la zone de détection synchrone (27) du capteur de détection synchrone (15) sur la première surface.

9. Appareil selon une des revendications 1 à 9, dans lequel le mécanisme de balayage optique comprend
une unité de lentille cylindrique (21) comprenant une lentille cylindrique (22) disposée vis-à-vis de la carte de circuit (23) par rapport au capteur de détection synchrone (15), et comprenant des parties saillantes servant de sixièmes repères (37a, 37b, 37c, 37d) indiquant une position correspondant à une position spécifique de la zone de détection synchrone (27) du capteur de détection synchrone (15) sur la première surface.

10. Appareil selon la revendication 1, dans lequel le premier repère (28) est constitué d'un élément pouvant être visiblement distingué.

11. Appareil selon la revendication 10, dans lequel le premier repère (28) est constitué par des moyens d'impression ou par un réflecteur.

12. Appareil selon la revendication 7, dans lequel les quatrièmes repères (35a, 35b) sont formés d'une seule pièce avec le support.

13. Appareil selon la revendication 9, dans lequel les sixièmes repères (37a, 37b, 37c, 37d) sont formés d'une seule pièce avec l'unité de lentille cylindrique (21).

14. Appareil selon l'une des revendications 1 à 13, dans lequel la carte de circuit (23) et le capteur de détection synchrone (15) sont installés conjointement en tant qu'unité de capteur de détection synchrone (33) dans un boîtier (34) d'un appareil d'écriture optique.

15. Appareil selon l'une des revendications 1 à 13, dans lequel le boîtier (34) comporte un orifice (42) permettant de voir la surface (23a) en vis-à-vis de la première surface de la carte de circuit (23) sur laquelle le capteur de détection synchrone (15) est monté, un couvercle (41) étant configuré pour empêcher les contaminants d'entrer dans l'appareil, et le couvercle (41) comprend ledit orifice (42).

16. Appareil selon la revendication 15, dans lequel l'orifice (42) comporte un élément d'étanchéité pouvant être ouvert/fermé (43) configuré pour recouvrir l'orifice (42).

17. Appareil de formation d'images, comportant :
un support d'image (5) ; et
un appareil d'écriture optique selon l'une des revendications 1 à 16.
